# EUROPEAN PATENT SPECIFICATION

(11) **EP 3 261 122 B1**
(45) Date of publication and mention of the grant of the patent: **30.10.2019**
(21) Application number: 16176222.4
(22) Date of filing: 24.06.2016
(51) Int. Cl.: H01L 27/146

(54) **3D-INTEGRATED OPTICAL SENSOR AND METHOD OF PRODUCING A 3D-INTEGRATED OPTICAL SENSOR**
3D-INTEGRIERTER OPTISCHER SENSOR UND VERFAHREN ZUR HERSTELLUNG EINES 3D-INTEGRIERTEN OPTISCHEN SENSORS
CAPTEUR OPTIQUE INTÉGRÉ 3D ET PROCÉDÉ DE PRODUCTION DE CAPTEUR OPTIQUE INTÉGRÉ 3D

(43) Date of publication of application: 27.12.2017
(73) Proprietor: ams AG, 8141 Premstätten (AT)
(72) Inventor: Enichlmair, Hubert, 8044 Weinitzen (AT); Schrems, Martin, 8063 Eggersdorf (AT); Toschkoff, Gregor, 8054 Graz (AT); Bodner, Thomas, 8054 Seiersberg (AT); Manninger, Mario, 8141 Premstätten (AT)
(74) Representative: Epping - Hermann - Fischer

(56) References cited:
- EP-A1- 2 772 939
- EP-A1- 2 873 953
- EP-A1- 3 032 583
- US-A1- 2012 187 281
- Schott: "Interference Filters & Special Filters", , 31 December 2015 (2015-12-31), XP055318984, Retrieved from the Internet: URL:http://www.schott.com/d/advanced_optic s/bffb1c3f-04d2-49fb-85b9-cdb6245e3d47/1.0 /schott-interference-filters-and-special-f ilters-description-2015-eng.pdf [retrieved on 2016-11-14]

## Description

This invention relates to a 3D-Integrated optical sensor and to a method of producing a 3D-Integrated optical sensor. Optical sensors such as ambient light sensors or true color sensors are typically equipped with one or more optical interference filters. These filters reflect one or more spectral bands or spectral lines and transmit others, while maintaining a nearly zero coefficient of absorption for those wavelengths of interest. Their optical properties are due to multiple thin layers of dielectric material having different refractive indices.

Optical interference filters are typically designed for normal incidence. However, when the angle of incidence of incoming light is increased from zero, the center wavelength of the filter will shift toward shorter (i.e. blue) wavelengths as the angle of incidence increases. In fact, the greater the angle the greater the shift. This so called "blue shifting" is often unwanted and limits performance of optical sensors such as ambient light sensors or true color sensors. Different solutions have been proposed to overcome the limitations of spectral shift on optical sensor performance when using interference filters. For example, mechanical apertures have been mounted on top of the optical sensor to limit the angle of incidence before light strikes the sensor. However, this leads to large heights which are typically not compatible with mobile device requirements. Other solutions involve diffusers which are attached to the optical sensors. However, the interference filters need to be adapted in their design to work with diffusers, i.e. multiple thin layers of dielectric material are adjusted with respect to optical and material properties, in order to reduce spectral shift. This often involves complex simulations and cannot generally be applied to different sensor designs. Achieving sufficient field of view paired with low spectral shift remains a challenge.

EP 3032583 A1 shows an integrated optical sensor with a semiconductor substrate, an integrated circuit, a dielectric layer, a wiring, a structured filter layer and a diffuser. The integrated circuit is arranged in the substrate at or near a main surface. Furthermore, the integrated circuit comprises at least one light sensitive component. The dielectric layer comprises at least one compound of the semiconductor material and is arranged on or above the main surface. The wiring is arranged in the dielectric layer and provides an electrical connection to the integrated circuit, i.e. the wiring is connected to the integrated circuit. The structured filter layer is arranged on the dielectric layer and faces the at least one light sensitive component, i.e. the diffusor is positioned over the structured filter layer. In particular, the structured filter layer is adapted for diffused incident light. The diffuser is arranged on the structured filter layer. US 2012/187281 A1 relates to a light sensor a having transparent substrate and through substrate vias and EP 2873953 A shows a light sensor arrangement for a spectrometer.

It is an object of the present principle to provide a 3D-Integrated optical sensor and a method of producing a 3D-Integrated optical sensor which allow reducing the limits of filter spectral shift.

This objective is achieved by the subject matter of the independent claims. Further developments and embodiments are described in the dependent claims.

In at least one embodiment a 3D-Integrated optical sensor according to claim 1 comprises a semiconductor substrate, an integrated circuit, a wiring, the filter layer or layers, a transparent spacer layer and an on-chip diffuser.

The semiconductor substrate has a main surface. For example, the substrate comprises a material such as silicon, silicon dioxide, aluminum oxide, sapphire, germanium, gallium arsenide (GaAs), an alloy of silicon and germanium, or indium phosphide (InP) and the like. Components of the optical sensors are deposited on or integrated into the main surface by means of 3D integration in a semiconductor process at wafer-level, e.g. by means of a CMOS process. The term "3D-Integration relates to manufacturing an integrated circuit by stacking substrates such as silicon wafers and/or dies and interconnecting them vertically. The substrate may provide for additional electronic components such as terminals to interface the sensors, or further on-chip components such as a driver circuit, A/D converter, etc., i.e. generally means to operate and interface the optical sensor.

The integrated circuit has at least one light sensitive area and is arranged in the substrate at or near the main surface. For example, the integrated circuit may be a semiconductor device that converts electromagnetic radiation into a sensor signal, such as a photocurrent in case of a photodiode. The term "light" hereinafter denotes electromagnetic radiation predominantly in the visible range between wavelengths from about 390 to 700 nm. In a broader sense "light" may also include parts of the infrared, visual and/or ultraviolet (UV). Further integrated circuit may be implemented alongside the (first) integrated circuit, for example in order to provide a sensor array. Examples of integrated circuits include photodiodes, CCDs or CMOS photo sensors.

The wiring is arranged on or in the semiconductor substrate. The wiring is connected to the integrated circuit and, thus, provides electrical connection to the integrated circuit. For example, the electrical components can be connected to the optical sensor by means of the wiring.

The filter layer is arranged on the integrated circuit such that it at least covers the light sensitive area. The filter layer comprises an interference filter and/or a plasmonic filter and has a direction dependent transmission characteristic. This indicates that the optical properties of the filter layer depend on the angle of incidence of light striking the optical sensor. Normal incidence is defined for a central wavelength which eventually is spectrally shifted when the angle of incidence increases.

The transparent spacer layer is arranged on the main surface such that the filter layer is at least partly enclosed by the spacer layer, wherein the transparent spacer layer is arranged directly on the filter layer. A spacer thickness is arranged to limit a spectral shift of the filter layer. The on-chip diffuser is arranged directly on the transparent spacer layer and on the filter layer.

The transparent spacer layer of the 3D-Integrated optical sensor provides a defined working distance between the filter layer and the diffuser, for example. Typically, light leaves the diffuser with certain angle distribution which is determined by material and optical properties of the diffuser. On the other side, the transmission characteristic of the filter layer also depends on an angle distribution of light striking filter, e.g. shifts with increasing angle of incidence. In order to limit spectral shift to a certain degree diffuser and filter layer need to be placed within a certain predetermined working distance. This working distance is provided by the transparent spacer layer, for example. In particular, by providing a sufficient spacer thickness, determined by the diffuser and filter layer material and optical properties, the spectral shift can be limited. This way the diffuser can be used to increase the field of view but still angles of incidence of light striking the filter layer can be restricted. It is not necessary for the filter layer to have a dedicated filter structure which may be especially adapted for the angle distribution provided by the diffuser.

This approach offers low z-height and low process complexity and cost. Furthermore the solution avoids the need for filter redesign at the same time. This is supported by the transparent spacer layer that is transparent to the radiation of interest such as infrared (IR) light, visible light or ultraviolet (UV-A/UV-B) light. Preferably, the diffuser and the transparent spacer layer are molded onto the other components, i.e. substrate, integrated circuit and/or filter layer using clear mold, for example. The transparent spacer layer creates the necessary working distance or even a minimum sufficient distance between filter layer and the diffuser. For example, this minimizes number and complexity of mold steps needed and may be a key advance in reducing cost and complexity of manufacture. Typically only two low complexity, planar molds are necessary in some embodiments. Furthermore, there is no need for filter redesign and a given filter layer design can be used with different optical sensors by just adjusting the spacer thickness. There is also no need for a mechanical aperture for most applications. As the diffuser is implemented on-chip in a semiconductor process there is also no need for an external diffuser. A semiconductor process can be carried out at wafer-level such that many optical sensor devices can be produced at the same time. For example, CMOS compatible process steps can be manufactured on wafer-level with lowest additional costs. In at least one embodiment the spacer thickness is smaller or equal than a thickness of the on-chip diffuser.

In the at least one embodiment the transparent spacer layer is arranged directly on the filter layer. For example, the transparent spacer layer is directly arranged on the filter layer by means of wafer-level molding as part of 3D-Integration. In fact, during the 3D-Integration, the filter layer, e.g. multiple dielectric layers, is (are) also applied to the substrate at wafer-level.

In at least one embodiment the transparent spacer layer extends over an area larger or equal than 50% of the main surface. Furthermore, the transparent spacer is centered on the light sensitive area. In particular, the spacer layer extends over an area larger than 60%, 70%, 80%, or 90% of the main surface. Furthermore, it is possible to arrange the transparent spacer layer such that it extends over the whole area of the main surface.

The extent of the transparent spacer layer has an influence on possible stray light entering the optical sensor. If the spacer layer is made smaller than the whole area of the main surface then cite portions at an edge of the substrate can be covered by the diffuser or other structures instead. Unwanted stray light is prevented from entering the light sensitive area. On the other side extending the transparent spacer layer over the whole area of the main surface may allow for easier and thus more cost-efficient manufacture of the optical sensor.

In at least one embodiment the transparent spacer layer comprises a transparent organic polymer, silicone or epoxy material. Alternatively, or in addition, the on-chip diffuser comprises the same material as the transparent spacer layer. However, the material of the diffuser comprises light scattering particles.

The material for the transparent spacer layer needs to be compatible with wafer-level manufacture, for example in a semiconductor process. Transparent organic polymer, silicone or epoxy material fulfill this requirement. Furthermore, while other material, such as epoxy, may be used, the wafer-level stress can be managed and transparency is ensured, the use of low stress silicones are preferred because they create only very low stress on top of silicon wafers. There are materials available that are also UV transparent and do not degrade over time, for example EG6301.

Using the same material for the on-chip diffuser and the transparent spacer layer renders wafer-level manufacture easier. The diffuser properties can be established by adding light scattering particles into the material. For example, metal oxide particles such as TiO₂ provide light scattering in transparent molds.

In at least one embodiment the filter layer extends over an area equal or larger than 50% of the main surface. In particular, the filter layer extends over an area larger than 60%, 70%, 80%, or 90% of the main surface. In fact, the filter layer can also be implemented to cover the whole area of the main surface.

The extent of the filter layer also has an influence on possible stray light entering the optical sensor. If the filter layer is made smaller than the whole area of the main surface then cite portions at an edge of the substrate can be covered by the diffuser or other structures instead. Unwanted stray light is prevented from entering the light sensitive area. On the other side extending the filter layer over the whole area of the main surface may allow for easier and thus more cost-efficient manufacture of the optical sensor.

In at least one embodiment the filter layer extends over the same area than at the transparent spacer layer.

In at least one embodiment of the filter layer is at least partly framed by a light blocking structure. The light blocking structure is arranged at edge areas of the main surface. The light blocking structure prevents stray light from entering the optical sensor. For example, the light blocking structure can be manufactured by molding at wafer-level, e.g. using an opaque mold material. Alternatively, or in addition, the light blocking structure can also be implemented by a frame comprising other material which is compatible with a wafer-level semiconductor process, such as a semiconductor, metal such as aluminum or a filter layer blocking light in unwanted wavelength regions.

In the at least one embodiment the filter layer comprises an interference filter. Alternatively or in addition the filter layer comprises a plasmonic filter. These are examples of filters having a direction dependent transmission characteristics. Furthermore, they can be applied at wafer-level in a semiconductor compatible process.

In at least one embodiment the optical sensor comprises an aperture array. The aperture array is arranged above or below the filter layer.

The required z-height for the transparent layer in order to avoid high incident angles, e.g. greater than 30°, for radiation incident on the diffuser may be higher than 1000µm. This maybe too much to comply with design requirements, for example when it is sought to use the optical sensor in a mobile device. Often only 50µm are available. Such low z-heights for transparent layers in combination with interference filters, for example, needs additional measures. The aperture array meets these requirements and allows for lower height of the optical sensor.

Therefore the concept of the transparent spacer layer may be combined with an aperture array. This can be implemented in a semiconductor process at wafer-level such as by means of CMOS layouts with typically no additional process steps.

In at least one embodiment the aperture array comprises a stack of metal layers. An upper metal layer faces away from the light sensitive area and has first apertures. A lower metal layer faces the light sensitive area and has second apertures. In fact, each first and second aperture confines an optical path in the aperture array, respectively.

The optical paths are designed for allowing incident light to reach the light sensitive area when having an angle of incidence from an allowed interval of angles. The allowed interval of angles is determined by the size of the first and second apertures and defined with respect to an optical axis of the optical paths, respectively. The upper and lower metal layers are made with a CMOS or semiconductor process. Preferably the layers are made from aluminum.

In at least one embodiment the aperture array comprises an aperture layer. The aperture layer is provided with an array of transparent aperture zones above the filter layer. Each of the aperture zones is penetrating into the aperture layer.

In at least one embodiment of the wiring comprises at least one through-substrate via. The through substrate via connects to a redistribution layer arranged on the backside of the semiconductor substrate opposite the main surface. Alternatively, the wiring comprises one or more bonding pads which are arranged in or on the main surface of the semiconductor substrate.

In at least one embodiment a method of producing a 3D integrated optical sensors comprises the steps disclosed in claim 12.

In at least one embodiment an aperture array is arranged above or below the filter layer and by means of a CMOS or semiconductor process.

In the following, the principle presented above is described in further detail with respect to drawings, in which exemplary embodiments are presented.
- Figure 1: shows an exemplary embodiment of an optical sensor,
- Figure 2: shows another exemplary embodiment of an optical sensor,
- Figure 3: shows a schematic exemplary embodiment of an optical sensor,
- Figures 4A, 4B, 4C: show a schematic exemplary embodiments of an optical sensor displayed from different directions,
- Figure 5A, 5B: show schematic exemplary embodiments of an optical sensor,
- Figure 6A, 6B: show schematic exemplary embodiments of an optical sensor,
- Figure 7A, 7B: show schematic exemplary embodiments of an optical sensor,

Figures 8A, 8B show exemplary embodiments of an aperture array, and

Figures 9A, 9B show other examples of an aperture array being useful to understand the present invention.

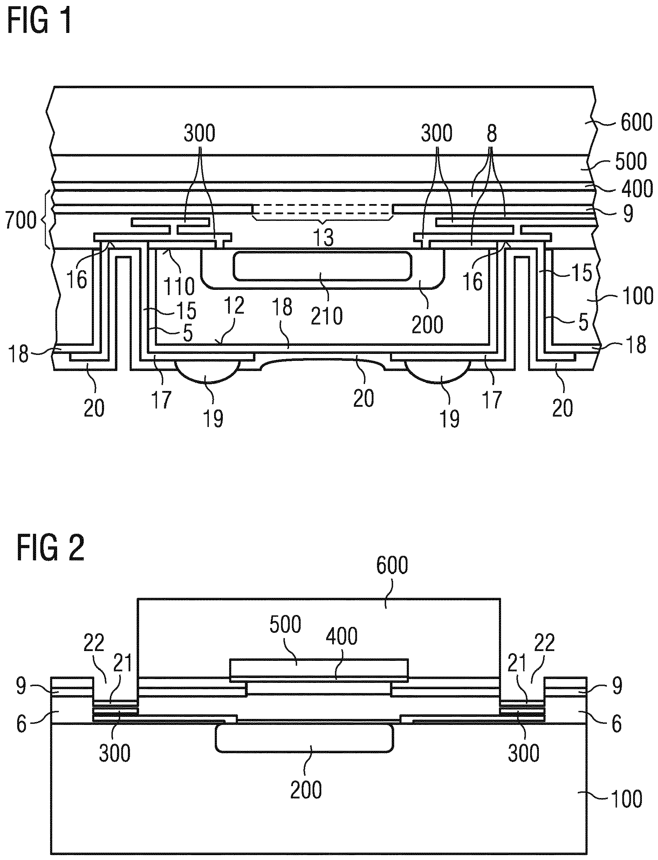

Figure 1 shows an exemplary embodiment of an optical sensor. The 3D integrated optical sensor comprises a semiconductor substrate 100, an integrated circuit 200, a wiring 300, a filter layer 400, a transparent spacer layer 500, and a diffuser 600. In this particular embodiment the optical sensor also comprises a dielectric layer 700 and several through silicon vias.

The semiconductor substrate 100 has a main surface 110. The integrated circuit 200 is arranged in the semiconductor substrate 100 near the main surface 110. The integrated circuit 200 has a light sensitive area 210. Typically, the semiconductor substrate 100 constitutes a silicon wafer, or part of a silicon wafer. In this particular embodiment the integrated circuit comprises one or more photodiodes, preferably photodiodes sensitive in the visual or near infrared range of the electromagnetic spectrum. The photodiodes may be integrated in a CMOS process technology. A single or a plurality of integrated optical sensors can be fabricated at a time and be singulated by means of a wafer dicing process at wafer-level.

The wiring 300 provides electrical connections to the integrated circuit 200. The wiring 300 is arranged in the semiconductor substrate. The wiring 300 is connected to the integrated circuit 200 and, thus, provides electrical connection to the light sensitive area 210. The dielectric layer 700 comprises the wiring 300 and is formed as a structured metal layer, in this example. The wiring 300 is used to provide electrical connections to power supply and components outside the integrated optical sensor. In this embodiment this is implemented by through substrate vias 5. The through substrate vias 5 shown in this drawing comprise a metallization 15 and penetrate into the semiconductor substrate 100. The through substrate vias 5 connect a contact area 16 of the wiring 300 by means of a rear wiring 17. The rear wiring 17 can be a redistribution layer or the like, or a patterned inter-metal layer, for example.

The dielectric layer 700 is arranged on the main surface 110 and provides a basis for the filter layer 400. The dielectric layer 700 comprises a material which is transparent to a target wavelength or wavelength region for which the optical sensor is intended to be used. Preferably, the dielectric layer 700 comprises at least one compound of a semiconductor material, for example, an oxide or nitride of a semiconductor material like silicon. Typically, the optical sensor is sensitive to visual and near infrared electromagnetic radiation. Silicon dioxide or SiO₂ provides such properties. Furthermore, the inter-metal layer 8 of the wiring 300 is arranged in the dielectric layer 700.

Optionally, a passivation layer 9 can be embedded into the dielectric layer 6. The passivation layer 9 can have a further dielectric material like a nitride of the semiconductor material, especially Si₃N₄, for example. Preferably, the passivation layer 9 has an aperture 13 above the light sensitive area 210. Alternatively, the passivation layer 9 comprises an entire layer, as indicated in Figure 1 by dashed lines.

A further dielectric layer 18 is provided at a rear side of the substrate 100 and/or on a sidewall of the through silicon vias 5. This dielectric layer 18 insulates the metallization 15 and/or the rear wiring 17 from the semiconductor material of the substrate 100. Bumps 19 are connected to the rear wiring 17 for external electric connection. Furthermore, a passivation 20 covering parts of the rear side are not used for external electric connection. The passivation 20 may be a deposited silicon nitride layer, for example, and may especially be applied to provide a moisture barrier and/or a mechanical protection for the metal of the rear wiring 17 and the through silicon via 5.

The filter layer 400 is arranged on the main surface of the dielectric layer 700 or immediately on the dielectric layer 700. In a wafer-level process, the filter layer 400 comprises several layers which may be sputtered or deposited on top of the last layer of the CMOS process (preferably a planarized oxide) by which the light sensitive area 210 or the integrated circuit 200 have been arranged into the optical sensor.

In this particular embodiment the filter layer 400 is an interference filter. In other embodiments (not shown) the filter layer 400 could also be a plasmonic filter. In both cases, the filter layer 400 comprises a stack of different partial layers. An interference filter, for example, comprises alternating layers of dielectric materials with different index of refraction in the target spectrum. The thicknesses of the individual layers are determined by a filter design, for example by means of a dedicated filter design software.

The filter layer 400 has a transmission characteristic which is determined by its filter design. The transmission characteristic is a function of angle of incidence. In this sense the transmission of the filter layer 400 is direction dependent. Examples of interference filters include cut-off filters, photopic filters, color filters, band pass filters and any combination thereof.

The transparent spacer layer 500 is arranged on the filter layer 400 (see Figures below for further details). A spacer thickness provides for a certain distance between the filter layer 400 and the diffuser 600. Typically, a combination of filter layer and diffuser is characterized by a working distance. If placed within the working distance a spectral shift of the transmission characteristics (i.e. its center wavelength) is kept within given limits under changing angles of incidence. For example, the spectral shift can be kept constant (or within ± 1nm, ± 2nm, ± 5nm, etc.) under angles of incidence from an interval smaller than ±30°, ±20°, ±10°, etc., for example. Light incident on the diffuser 600 leaves with a diffusive distribution of angles. These angles would lead to larger or unwanted spectral shift when striking the filter layer 400. Due to the working distance established by the spacer thickness, however, only angles of incidence from a smaller interval are incident on the filter layer 400. Thus, spectral shift can be restricted to a degree determined (among other parameters) by the properties of the transparent spacer layer 500. Different embodiments are possible and some examples are discussed below.

The transparent spacer layer 500 comprises an epoxy material, for example. Alternatively, the transparent spacer layer 500 may also comprise a silicone, i.e. in general a synthetic polymer compound. Silicone can be transparent in the visual and near infrared range. Furthermore, both epoxy and silicone can be applied by wafer-level molding. It has also been found that these materials, when used on top of silicon wafers, reduce stress on other components. Furthermore, epoxy and silicone materials are available which are also transparent in the ultraviolet and do not degrade over time (see EG6301, for example).

The diffuser 600 is spun on or arranged by means of molding on top of the dielectric layer 700, for example. The diffuser 600 comprises a transparent organic layer having light scattering particles, for example. The light scattering particles typically have a size between 1 to 15 micrometers, for example. Generally, the size is chosen so that scattering within the diffuser 600 follows the laws of geometric optics so that, essentially, scattering does not depend on wavelength. Light leaves the diffuser 600 with an angle having a diffusive distribution of angles. Furthermore, both the material of the diffuser 600 and of the light scattering particles are chosen not to absorb in the target wavelength region. The diffuser thickness typically ranges within 20 to several 100 micrometers. The diffuser material preferably is the same as that of the transparent spacer layer 500.

During operation of the optical sensor light is incident and enters via the diffuser 600. Light may be incident in a parallel way or as diffused incident light originating from different directions. In both cases, the incident light leaves the diffuser 600 with the diffusive distribution of angles. Due to the working distance defined by the spacer thickness only light is incident on the filter layer 400 from a certain interval of angles. Said interval can be determined by the spacer thickness and can be enough to limit the spectral shift of the filter layer 400 to a certain predetermined maximum value.

The proposed optical sensor is an all 3D integrated design and all processing steps can be carried out in a semiconductor or CMOS compatible process at wafer-level with a low additional costs. The design diminishes the need of an external aperture or of an external diffusor in order to reduce angle dependency of the filter transmission characteristics. In fact, the diffuser is already part of the sensor package. Furthermore, different filter designs can be used without the need for a dedicated filter design adapted to fit to the diffuser. The overall design results in a superior angle dependence and reduced spectral shift due to the use of a direction dependent filter layer. This allows for a defined transmission characteristic for example, into color filters and photopic filters.

Figure 2 shows another exemplary embodiment of an optical sensor. Based on a similar overall design as in figure 1 and the wiring and an electrical connection can be implemented by means of one or more bonding pads 21. For easier representation not all components shown in Figure 1 also shown in Figure 2 but maybe present nonetheless.

The diffuser 600 is spun on or arranged by means of molding on top of the dielectric layer 700. However, the diffuser 600 leaves at least some parts of the surface of the dielectric layer 700 open to accommodate bonding pads 21. The bonding pads 21 are arranged into an opening 22 in the dielectric layer 700 and passivation layer 9. Furthermore, the bonding pads 21 comprise the wiring 300 formed as a structured metal layer. The bonding pads 21 provide electrical connectivity for power supply and to external components to read and receive an optical sensor signal for further processing.

For easier explanation a more schematic representation will be employed in the following drawings. The optical sensors discussed in the following can be implemented with through silicon vias 5 (shown in Figure 1) and/or bond pads 21 (shown in Figure 2). However, only the implementation with through silicon vias 5 is shown as the concepts can be applied to other embodiments of the optical sensor analogously.

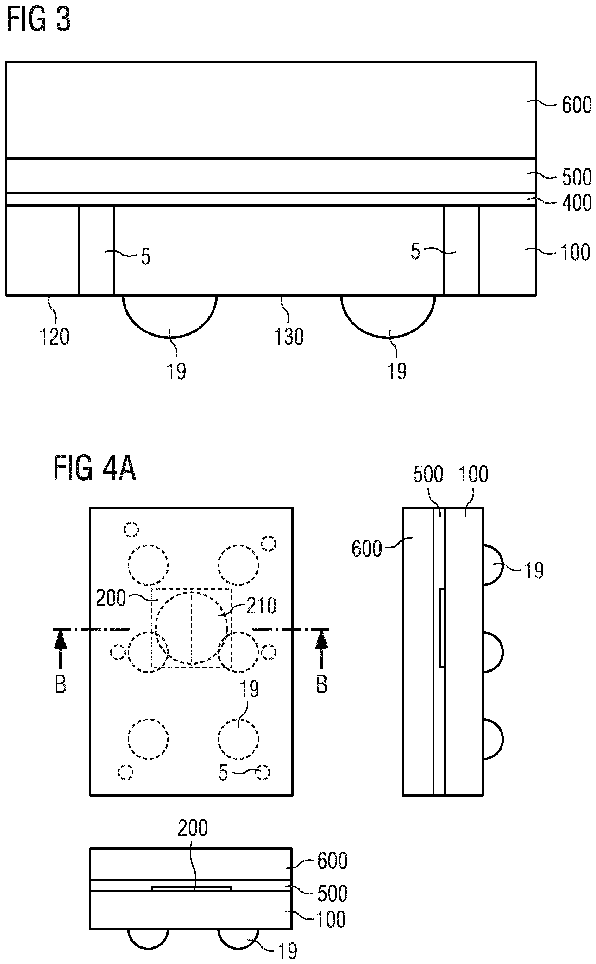

Figure 3 shows a schematic exemplary embodiment of an optical sensors. The drawing shows a side view of the optical sensor with diffuser 600, transparent spacer layer 500, and filter layer 400. The wiring 300 comprises trough silicon vias 5. The integrated circuit 200 comprises a light sensor such as a photodiode as light sensitive area 210 but is not shown for easier representation (see Figures 1 and 2 for details). A backside 120 of the semiconductor substrate 100 comprises a redistribution layer 130 which can be connected by means of bumps 19. Other layers such as dielectric layer and passivation layer can be present as discussed earlier. However, they are not represented for easier representation.

In this particular embodiment the filter layer 400 is arranged on the main surface 110. In fact, in this example the filter layer 400 covers most of the (or the whole) main surface 110. This renders production of the optical sensor easier as the filter layer does not have to be positioned or aligned on the main surface in an overly precise manner. The transparent spacer layer 500 is arranged on the filter layer 400. In fact, the transparent spacer layer covers most of the (or the whole) area of the filter layer 500, i.e. the filter layer 400 extends over the same area than the transparent spacer layer 500. Finally, the diffuser 600 is arranged on the transparent spacer layer 500. The diffuser 600 encloses the transparent spacer layer 500 as it is deposited on the whole area of the transparent spacer layer 500.

The term "transparent" relates to minor losses of incident radiation by absorption or reflection for the wavelengths of interest. In this meaning the diffuser 600 and the spacer layer 500 are transparent or at least translucent. The diffuser 600 comprises light scattering particles which scatter incident light into a distribution of angles. In this embodiment, diffuser 600 and transparent spacer layer 500 are made from the same (base) material, such as epoxy or silicone, for example.

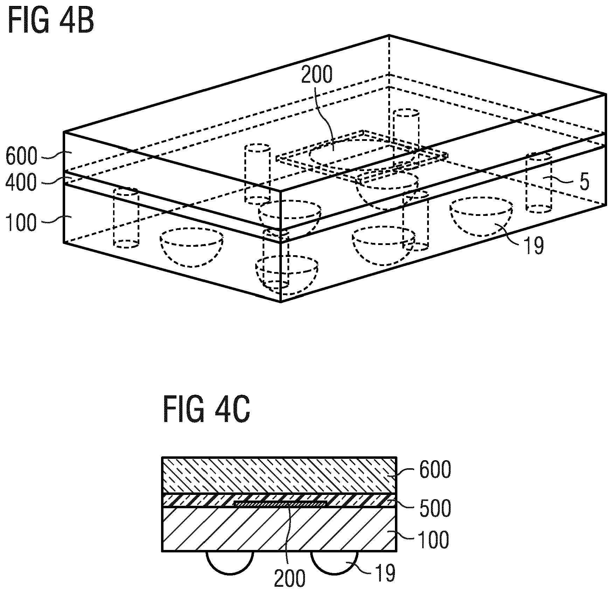

Figure 4 shows schematic exemplary embodiments of an optical sensor displayed from different directions. In fact, this drawing shows exemplary dimension of an implementation of the optical sensor in Figure 3.

Section A shows a top view of the optical sensor. The device has a length of 1.66 mm and width of 1.145 mm. Depicted are also several through silicon vias and bumps (see dashed circles). Furthermore, the integrated circuit 200 and the light sensitive area 210 are indicated by dashed lines as well. The drawing is accompanied with side views along the length and width of the optical sensor. Section B shows a 3D-view from an angle to highlight how the features stand out in the optical sensor. Clearly visible are several through silicon vias extending into the semiconductor substrate and bumps distributed on the backside 120 of the substrate 100 (in the redistribution layer, for example). In this embodiment the optical sensor has an overall height of 0.418 mm. Section C shows a section from the optical sensor cut along direction B-B (as indicated in Section A). The diffuser has a thickness of 0.150 mm and the spacer thickness is 0.050 mm. An overall device height (measured from an underside of bump to an outer surface of the diffuser 600 is 0.518 mm. These dimensions are to be understood as examples only rather than any restriction to exact values.

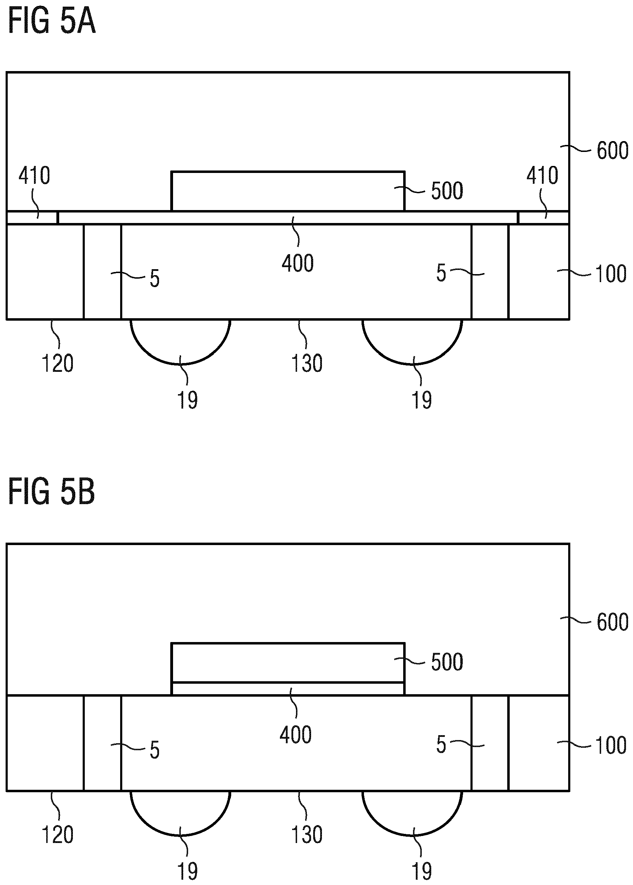

Figure 5A, 5B show schematic exemplary embodiments of an optical sensor. These embodiments correspond to the one presented in Figure 3 but have different implementations of the filter layer and transparent spacer layer.

In Figure 5A the filter layer 400 and transparent spacer layer 500 do not cover the same area. In fact, the transparent spacer layer 500 is structured such that the diffuser 600 directly interfaces with parts of the filter layer 400, for example in edge areas of the substrate 100. This is intended to prevent penetration of stray radiation from the side by light pipe effects. Additionally, optional blocking structures 410 such as black filters are arranged at edges of the optical sensors to prevent light pipe effects from the side in the filter region.

Figure 5B shows a similar approach wherein the transparent spacer layer 500 is structured such that the diffuser 600 directly interfaces with parts of the filter layer 400, for example in edge areas. In this embodiment the filter layer 400 extends over the same area than the transparent spacer layer 500 but leaves edge areas of the substrate free. The edge areas interface with the diffuser 600 directly such that the diffuser encloses the filter layer 400 and transparent spacer layer 500 completely. Due to light scattering in the diffuser 600 stray light is prevented from reaching the light sensitive area 210. Light blocking structures such as black filters can be added optionally to further reduce light piping effects.

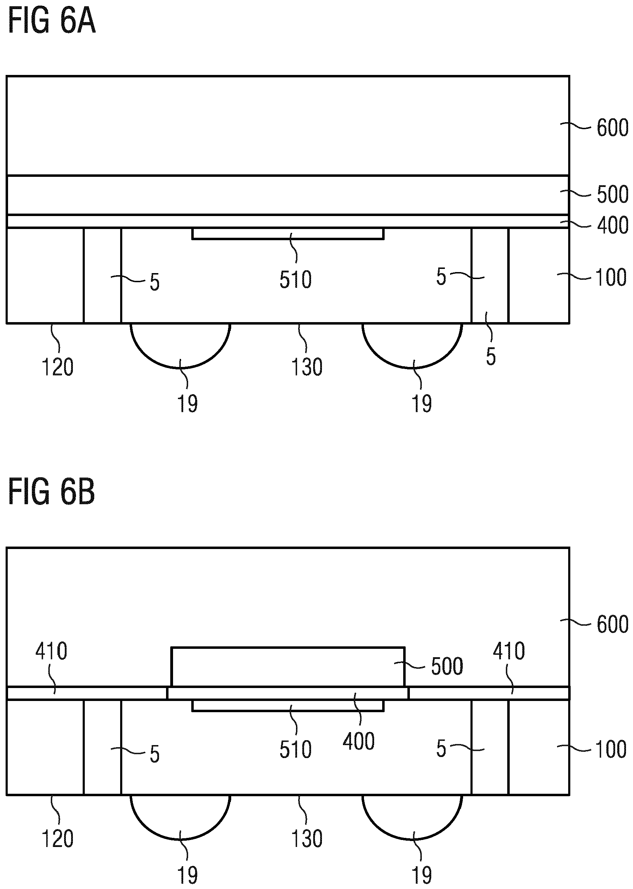

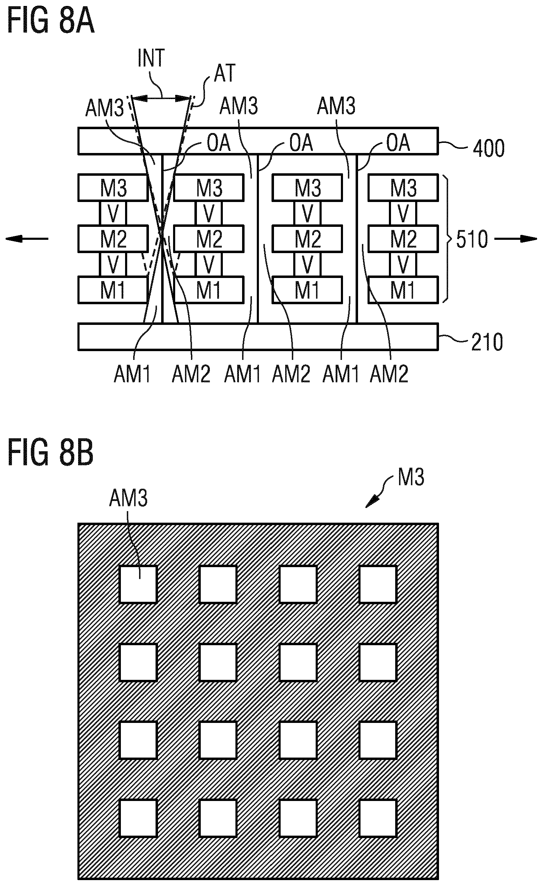

Figure 6A, 6B show schematic exemplary embodiment of an optical sensor. These embodiments show optional aperture arrays 510 to limit the incident angle, e.g. to smaller than ± 30 or ± 10 degrees before radiation enters the light sensitive areas, such as photodiodes. The aperture arrays 510 comprise a stack of metal layers formed by CMOS metallization for example and will be explained in more detail in Figures 8A and 8B. However, other materials than metal are possible, if compatible with a semiconductor process at wafer-level.

The embodiment shown in Figure 6A corresponds to the one shown in Figure 3 but with an additional aperture array 510 of stacked metal layers arranged between the light sensitive area 210 (or integrated circuit 200) and the filter layer 400. The embodiment shown in Figure 6B corresponds to the one of Figures 5A or 5B but with an additional aperture array 510 arranged between the light sensitive area 210 (or integrated circuit 200) and the filter layer 400. Alternatively, the aperture array 510 can also be arranged on the filter layer 400 instead of below.

The spacer thickness of the transparent layer is adjusted in order to avoid high incident angles, e.g. greater than 30°, for radiation incident on the diffuser 600. However, as discussed above the spacer thickness may be higher than 1000µm under some circumstances. This typically is too much to comply with design requirements, for example when the optical sensor is implemented in a mobile device. The aperture array 510 allows for lower height of the optical sensor. In fact, the concept of the transparent spacer layer can be combined with an aperture array 510 as shown in Figures 6A and 6B. The proposed metal stack can be implemented in a semiconductor process at wafer-level such as by means of CMOS layouts with typically no additional process steps.

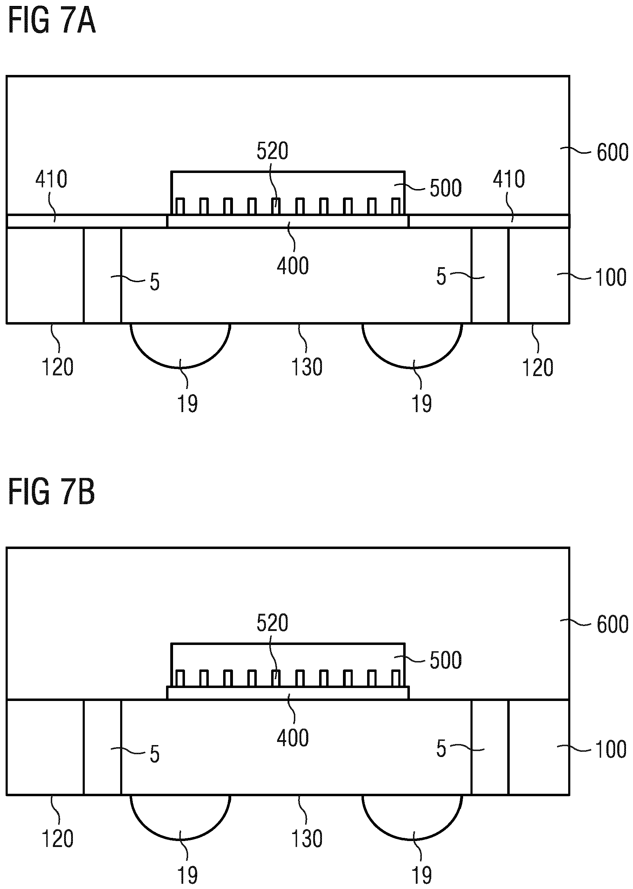

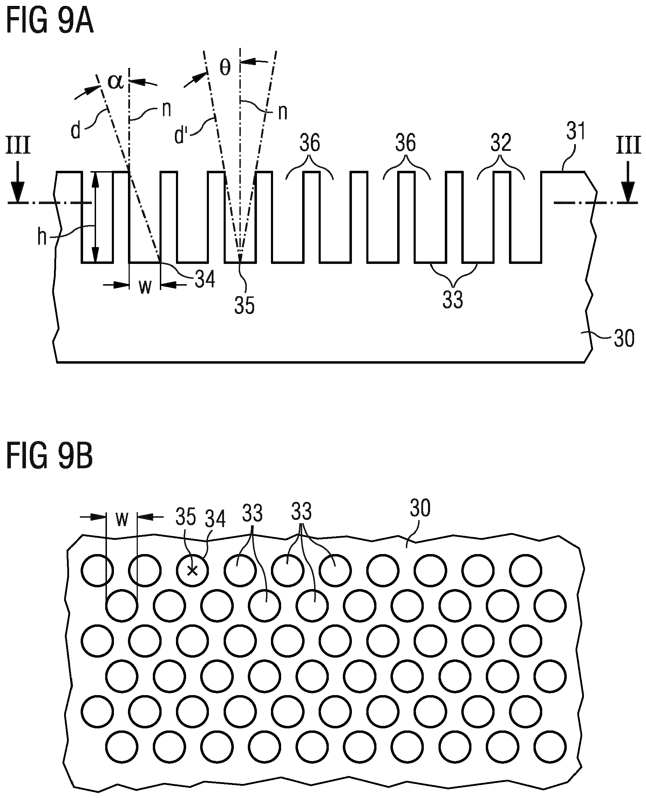

Figures 7A and 7B show schematic exemplary embodiments of an optical sensor. These embodiments show optional aperture arrays to limit the incident angle to smaller angles before radiation enters the light sensitive areas. The aperture arrays comprise aperture layers having an array of transparent aperture zones formed by deposition and structuring at wafer-level and after forming the filter layer, i.e. the aperture layers are arranged on the filter layer. Details will be explained in more detail in Figures 9A and 9B.

The embodiments shown in Figure 6A and 6B correspond to the one shown in Figures 5A and 5B, respectively, but with an additional aperture layer above the light sensitive area 210 (or integrated circuit 200) and on the filter layer 400. Alternatively, the aperture layer 520 can also be arranged in the optical sensor of Figure 3. The aperture layer 520 also allows for lower height of the optical sensor. The proposed aperture layer 520 of aperture zones can be implemented in a semiconductor process at wafer-level such as by means of CMOS layouts with typically no additional process steps.

Figures 8A, 8B show exemplary embodiments of an aperture array. The aperture array 510 comprises a stack of metal layers, or any other opaque material compatible with a semiconductor process such as a CMOS process.

The stack in Figure 8A comprises three layers M1, M2, M3 which are stacked onto one another by vias V. The stack is formed by a semiconductor or CMOS metallization. A lower opaque layer M1 faces the light sensitive area 210 and has apertures AM1. An intermediate opaque layer M2 is arranged over the lower opaque layer M1 and has apertures AM2. An upper opaque layer M3 faces away from the light sensitive area 21 and has apertures AM3. The aperture, AM3, AM2, AM3 each confine an optical path in the aperture array, respectively.

The optical paths allow incident light to reach the light sensitive area 210 only when having an angle of incidence from an allowed interval of angles INT. The interval is determined by the size and shape of the apertures AM1, AM2, AM3. Furthermore, the angles of incidence are defined with respect to an optical axis OA of the optical paths, respectively. Typically, an angle of zero degrees is denoted normal incidence and light is parallel to the optical axis OA.

Figure 8B shows one opaque layer M3 in top view as an example. In this particular embodiment the layer M3 comprises squared shaped apertures M3. Preferably, the other layers M1, M2 have same or similarly shaped apertures AM1, AM2, AM3, respectively. Other shapes such as circles, rectangles, etc.

Figures 9A, 9B show other examples of an aperture array being useful to understand the present invention. Figure 9A shows a cross section of an aperture array based on a layer of apertures. The aperture layer 520 comprises a further semiconductor substrate 30, for example a further silicon wafer. Figure 9B shows a top view of the aperture layer.

Aperture zones 36 are formed into a main surface 31 of the further semiconductor substrate 30, for example by etching recesses 32. In this example the recesses 32 and hence the aperture zones 36 have the same size, in particular the same width w and the same height h perpendicular to the main surface 31. In other examples the aperture zones 36 may have varying sizes and/or shape.

The aperture layer 520 is arranged and centred on the filter layer 400 and limits angles of incidence of light to reach the light sensitive area 210. A normal n to the main surface 31 and a direction d are depicted in the drawing. Incident radiation having the direction d (or smaller angles of incidence) can reach a periphery 34 at a bottom 33 of the aperture zones 36 (indicated by dash-dotted lines forming an angle α). The angle α can be restricted such that the field of view is confined by a cone having an aperture equal to twice the maximal angle θ between the normal n to the main surface 31 and any direction d' of incident radiation reaching the centre 35 of the bottom 33 of an aperture zone 36. Figure 9B shows a top view of the aperture layer, wherein the shape of the aperture zones 36 is circular. Other shapes can be implemented as well, such as square, rectangular, pentagonal, hexagonal shapes etc.

### Reference numerals

- 5: through substrate via
- 8: inter-metal layer
- 9: passivation layer
- 13: aperture
- 15: metallization
- 16: contact area
- 17: rear wiring
- 18: dielectric layer
- 19: bumps
- 20: passivation
- 21: bonding pad
- 22: opening
- 30: substrate
- 31: main surface
- 32: etching recess
- 33: bottom
- 34: periphery
- 35: centre
- 36: aperture zones
- 100: semiconductor substrate
- 110: main surface
- 120: backside
- 130: redistribution layer
- 200: integrated circuit
- 210: light sensitive area
- 300: wiring
- 400: filter layer
- 500: transparent spacer layer
- 510: aperture array
- 520: aperture layer
- 600: diffuser
- 700: dielectric layer
- d: direction
- d': direction
- h: height
- n: normal
- w: width
- α: angle of incidence
- θ: maximal angle

## Claims

1. 3D-Integrated optical sensor, comprising:
- a semiconductor substrate (100) having a main surface (110) ,
- an integrated circuit (200) comprising at least one light sensitive area (210), the integrated circuit (200) being arranged in the substrate (100) at or near the main surface (110) ,
- a wiring (300) for providing electrical connection to the integrated circuit (200), the wiring (300) being arranged on or in the semiconductor substrate (100) and being connected to the integrated circuit (200),
- a filter layer (400) arranged on the integrated circuit (200), wherein the filter layer (400) at least covers the light sensitive area (210), and wherein the filter layer (400) comprises an interference filter and/or a plasmonic filter,
- a transparent spacer layer (500) arranged on the main surface (110) and at least partly enclosing the filter layer (400), wherein the transparent spacer layer (500) is arranged directly on the filter layer (400), and
- an on-chip diffuser (600) arranged directly on the transparent spacer layer (500) and on the filter layer (400), **characterized in that**
a spacer thickness is arranged to limit a spectral shift of the filter layer (400) such that the spectral shift is constant or within ± 5nm under angles of incidence from an interval smaller than ±30°, wherein a central wavelength of the filter layer (400) is defined with respect to normal incidence and is spectrally shifted when the angle of incidence of light striking the filter layer (400) increases.

2. 3D-Integrated optical sensor according to claim 1, wherein the spacer thickness is smaller than a thickness of the on-chip diffuser (600).

3. 3D-Integrated optical sensor according to claim 1 or 2, wherein the transparent spacer layer (500) extends over an area larger than 50% of the main surface (110) centered on the light sensitive area; in particular more than 60%, 70%, 80%, 90% of the main surface (110); or extends over the whole area of the main surface (110).

4. 3D-Integrated optical sensor according to one of claims 1 to 3, wherein
- the transparent spacer layer (500) comprises a transparent silicone or epoxy material and/or
- the on-chip diffuser (600) comprises the same material as the transparent spacer layer (500) with added light scattering particles.

5. 3D-Integrated optical sensor according to one of claims 1 to 4, wherein the filter layer (400) extends
- over an area larger than 50% of the main surface (110); in particular more than 60%, 70%, 80%, 90% of the main surface (110); or
- over the whole area of the main surface (110).

6. 3D-Integrated optical sensor according to one of claims 1 to 5, wherein the filter layer (400) extends over the same area than the transparent spacer layer (500).

7. 3D-Integrated optical sensor according to one of claims 1 to 6, wherein
- the filter layer (400) is at least partly framed by a light blocking structure (410),
- the light blocking structure (410) is arranged at an edge area of the main surface (110).

8. 3D-Integrated optical sensor according to one of claims 1 to 7, wherein an aperture array (520) is arranged above or below the filter layer (400).

9. 3D-Integrated optical sensor according to claim 8, wherein the aperture array comprises a stack of metal layers, further comprising:
- an upper opaque layer (M1) facing away from the light sensitive area (210) and having first apertures (AM1),
- a lower opaque layer (M2) facing the light sensitive area (210) and having second apertures (AM2), wherein each first and second aperture (AM1, AM2) confines an optical path in the aperture array (2), respectively,
- the upper and lower base (M1, M2) are made from metal, and
- the optical paths are designed for allowing incident light to reach the light sensitive area (210) when having an angle of incidence from an allowed interval of angles (INT) determined by the size of the first and second apertures (AM1, AM2) and defined with respect to an optical axis (OA) of the optical paths, respectively.

10. 3D-Integrated optical sensor according to claim 8, wherein the aperture array comprises an aperture layer (520) provided with an array of transparent aperture zones (36) above the filter layer, each of the aperture zones (36) penetrating the aperture layer (520).

11. 3D-Integrated optical sensor according to one of claims 1 to 10, wherein the wiring comprises
- at least one through-substrate via (5) electrically connected to a redistribution layer arranged on a backside of the semiconductor substrate (100) opposite the main surface, or
- bonding pads (21) arranged in or on the main surface of the semiconductor substrate (100).

12. Method of producing a 3D-Integrated optical sensor, comprising the steps of:
- providing a semiconductor substrate (100) with an integrated circuit (200) comprising at least one light sensitive area arranged in the substrate (100) at or near the main surface (110),
- arranging a wiring (300) on or in the semiconductor substrate (100) and connecting the wiring (300) to the integrated circuit (200),
- arranging a filter layer (400) on the integrated circuit (200) such that the filter layer (400) at least covers the light sensitive area (210), wherein the filter layer (400) comprises an interference filter and/or a plasmonic filter,
- arranging a transparent spacer layer (500) on the filter layer (400) and at least partly enclosing the filter layer (400), wherein the transparent spacer layer (500) is arranged directly on the filter layer (400), and
- arranging an on-chip diffuser (600) directly on the transparent spacer layer (500) and on the filter layer (400), **characterized in that**
- a spacer thickness is arranged to limit a spectral shift of the filter layer (400) such that the spectral shift is constant or within ± 5nm under angles of incidence from an interval smaller than ±30°, wherein a central wavelength of the filter layer (400) is defined with respect to normal incidence and is spectrally shifted when the angle of incidence of light striking the filter layer (400) increases.

13. Method according to claim 12, wherein an aperture array (420) is arranged above or below the filter layer (400) by means of a CMOS process.

## Patentansprüche

1. 3D-integrierter optischer Sensor, umfassend:
- ein Halbleitersubstrat (100) mit einer Hauptfläche (110),
- eine integrierte Schaltung (200), die mindestens einen lichtempfindlichen Bereich (210) umfasst, wobei die integrierte Schaltung (200) im Substrat (100) an oder nahe der Hauptfläche (110) angeordnet ist,
- eine Verdrahtung (300), um eine elektrische Verbindung zur integrierten Schaltung (200) bereitzustellen, wobei die Verdrahtung (300) auf oder im Halbleitersubstrat (100) angeordnet und an die integrierte Schaltung (200) angeschlossen ist,
- eine Filterschicht (400), die auf der integrierten Schaltung (200) angeordnet ist, wobei die Filterschicht (400) zumindest den lichtempfindlichen Bereich (210) bedeckt, und wobei die Filterschicht (400) ein Interferenzfilter und/oder ein Plasmonikfilter umfasst,
- eine transparente Abstandshalterschicht (500), die auf der Hauptfläche (110) angeordnet ist und zumindest teilweise die Filterschicht (400) einschließt, wobei die transparente Abstandshalterschicht (500) direkt auf der Filterschicht (400) angeordnet ist, und
- einen On-Chip-Diffusor (600), der direkt auf der transparenten Abstandshalterschicht (500) und auf der Filterschicht (400) angeordnet ist,
**dadurch gekennzeichnet, dass**
- eine Abstandshalterdicke eingerichtet ist, um eine Spektralverschiebung der Filterschicht (400) so einzugrenzen, dass die Spektralverschiebung konstant ist oder innerhalb von ± 5 nm unter Einfallswinkeln aus einem Intervall liegt, das kleiner als ± 30° ist, wobei eine zentrale Wellenlänge der Filterschicht (400) in Bezug auf einen normalen Einfall definiert und spektral verschoben ist, wenn der Einfallswinkel von auf die Filterschicht (400) auftreffendem Licht größer wird.

2. 3D-integrierter optischer Sensor nach Anspruch 1, wobei die Abstandshalterdicke kleiner ist als eine Dicke des On-Chip-Diffusors (600).

3. 3D-integrierter optischer Sensor nach Anspruch 1 oder 2, wobei sich die transparente Abstandshalterschicht (500) über einen Bereich, der größer ist als 50 % der auf den lichtempfindlichen Bereich zentrierten Hauptfläche (110); insbesondere mehr als 60 %, 70 %, 80 %, 90 % der Hauptfläche (110); oder sich über den gesamten Bereich der Hauptfläche (110) erstreckt.

4. 3D-integrierter optischer Sensor nach einem der Ansprüche 1 bis 3, wobei
- die transparente Abstandshalterschicht (500) ein transparentes Silikon- oder Epoxidmaterial umfasst, und/oder
- der On-Chip-Diffusor (600) dasselbe Material wie die transparente Abstandshalterschicht (500) mit zugesetzten lichtstreuenden Partikeln umfasst.

5. 3D-integrierter optischer Sensor nach einem der Ansprüche 1 bis 4, wobei sich die Filterschicht (400)
- über einen Bereich, der größer ist als 50 % der Hauptfläche (110); insbesondere mehr als 60 %, 70 %, 80 %, 90 % der Hauptfläche (110); oder
- sich über den gesamten Bereich der Hauptfläche (110) erstreckt.

6. 3D-integrierter optischer Sensor nach einem der Ansprüche 1 bis 5, wobei sich die Filterschicht (400) über denselben Bereich erstreckt wie die transparente Abstandshalterschicht (500) .

7. 3D-integrierter optischer Sensor nach einem der Ansprüche 1 bis 6, wobei
- die Filterschicht (400) zumindest teilweise von einer lichtblockierenden Struktur (410) eingerahmt ist,
- die lichtblockierende Struktur (410) in einem Randbereich der Hauptfläche (110) angeordnet ist.

8. 3D-integrierter optischer Sensor nach einem der Ansprüche 1 bis 7, wobei eine Öffnungsanordnung (520) über oder unter der Filterschicht (400) angeordnet ist.

9. 3D-integrierter optischer Sensor nach Anspruch 8, wobei die Öffnungsanordnung einen Stapel Metallschichten umfasst, darüber hinaus umfassend:
- eine obere opake Schicht (M1), die vom lichtempfindlichen Bereich (210) abgewandt ist und erste Öffnungen (AM1) hat,
- eine untere opake Schicht (M2), die dem lichtempfindlichen Bereich (210) zugewandt ist und zweite Öffnungen (AM2) hat, wobei jede erste bzw. zweite Öffnung (AM1, AM2) einen Strahlengang in der Öffnungsanordnung eingrenzt,
- die obere und untere Basis (M1, M2) aus Metall hergestellt sind, und
- die Strahlengänge dazu gestaltet sind, einfallendes Licht den lichtempfindlichen Bereich (210) erreichen zu lassen, wenn es einen Einfallswinkel aus einem zulässigen Intervall von Winkeln (INT) hat, das durch die Größe der ersten und zweiten Öffnung (AM1, A2) bestimmt bzw. in Bezug auf eine optische Achse (OA) der Strahlengänge definiert ist.

10. 3D-integrierter optischer Sensor nach Anspruch 8, wobei die Öffnungsanordnung eine Öffnungsschicht (520) umfasst, die mit einer Anordnung transparenter Öffnungszonen (36) über der Filterschicht versehen ist, wobei jede der Öffnungszonen (36) die Öffnungsschicht (520) durchdringt.

11. 3D-integrierter optischer Sensor nach einem der Ansprüche 1 bis 10, wobei die Verdrahtung umfasst:
- mindestens eine Substratdurchkontaktierung (5) die elektrisch an eine Umverteilungsschicht angeschlossen ist, die auf einer Rückseite des Halbleitersubstrats (100), der Hauptfläche entgegengesetzt angeordnet ist, oder
- Verbindungskontaktflecke (21), die in oder auf der Hauptfläche des Halbleitersubstrats (100) angeordnet sind.

12. Verfahren zum Herstellen eines 3D-integrierten optischen Sensors, die folgenden Schritte umfassend:
- Versehen eines Halbleitersubstrats (100) mit einer mindestens einen lichtempfindlichen Bereich umfassenden integrierten Schaltung (200), die im Substrat (100) an oder nahe der Hauptfläche angeordnet ist,
- Anordnen einer Verdrahtung (300) auf oder in dem Halbleitersubstrat (100), und Anschließen der Verdrahtung (300) an die integrierte Schaltung (200),
- Anordnen einer Filterschicht (400) auf der integrierten Schaltung (200) so, dass die Filterschicht (400) zumindest den lichtempfindlichen Bereich (210) bedeckt, wobei die Filterschicht (400) ein Interferenzfilter und/oder ein Plasmonikfilter umfasst,
- Anordnen einer transparenten Abstandshalterschicht (500) auf der Filterschicht (400) und zumindest teilweises Einschließen der Filterschicht (400), wobei die transparente Abstandshalterschicht (500) direkt auf der Filterschicht (400) angeordnet wird, und
- Anordnen eines On-Chip-Diffusors (600) direkt auf der transparenten Abstandshalterschicht (500) und auf der Filterschicht (400),
**dadurch gekennzeichnet, dass**
- eine Abstandshalterdicke eingerichtet ist, um eine Spektralverschiebung der Filterschicht (400) so einzugrenzen, dass die Spektralverschiebung konstant ist oder innerhalb von ± 5 nm unter Einfallswinkeln aus einem Intervall liegt, das kleiner als ± 30° ist, wobei eine zentrale Wellenlänge der Filterschicht (400) in Bezug auf einen normalen Einfall definiert und spektral verschoben ist, wenn der Einfallwinkel von auf die Filterschicht (400) auftreffendem Licht größer wird.

13. Verfahren nach Anspruch 12, wobei die Öffnungsanordnung (420) mittels eines CMOS-Prozesses über oder unter der Filterschicht (400) angeordnet wird.

## Revendications

1. Capteur optique intégré 3D, comprenant :
- un substrat semiconducteur (100) présentant une surface principale (110),
- un circuit intégré (200) comprenant au moins une aire sensible à la lumière (210), le circuit intégré (200) étant agencé dans le substrat (100) au niveau de ou près de la surface principale (110),
- une filerie (300) destinée à fournir une connexion électrique au circuit intégré (200), la filerie (300) étant agencée sur ou dans le substrat semiconducteur (100) et étant connectée au circuit intégré (200),
- une couche de filtre (400) agencée sur le circuit intégré (200), sachant que la couche de filtre (400) recouvre au moins l'aire sensible à la lumière (210), et sachant que la couche de filtre (400) comprend un filtre d'interférence et/ou un filtre plasmonique,
- une couche d'entretoise (500) transparente agencée sur la surface principale (110) et enfermant au moins en partie la couche de filtre (400), sachant que la couche d'entretoise (500) transparente est agencée directement sur la couche de filtre (400), et
- un diffuseur sur puce (600) agencé directement sur la couche d'entretoise (500) transparente et sur la couche de filtre (400),
**caractérisé en ce que**
- une épaisseur d'entretoise est agencée pour limiter un décalage spectral de la couche de filtre (400) de sorte que le décalage spectral soit constant ou compris dans ± 5 nm sous des angles d'incidence à partir d'un intervalle inférieur à ± 30°, sachant qu'une longueur d'onde centrale de la couche de filtre (400) est définie par rapport à une incidence normale et est spectralement décalée lorsque l'angle d'incidence de lumière frappant la couche de filtre (400) augmente.

2. Capteur optique intégré 3D selon la revendication 1, sachant que l'épaisseur d'entretoise est inférieure à une épaisseur du diffuseur sur puce (600).

3. Capteur optique intégré 3D selon la revendication 1 ou 2, sachant que la couche d'entretoise (500) transparente s'étend sur une aire supérieure à 50 % de la surface principale (110) centrée sur l'aire sensible à la lumière ; en particulier plus de 60 %, 70 %, 80 %, 90 % de la surface principale (110) ; ou s'étend sur toute l'aire de la surface principale (110) .

4. Capteur optique intégré 3D selon l'une des revendications 1 à 3, sachant que
- la couche d'entretoise (500) transparente comprend un matériau en silicium ou époxy transparent et/ou
- le diffuseur sur puce (600) comprend le même matériau que la couche d'entretoise (500) transparente avec des particules de diffusion de lumière ajoutées.

5. Capteur optique intégré 3D selon l'une des revendications 1 à 4, sachant que la couche de filtre (400) s'étend
- sur une aire plus grande que 50 % de la surface principale (110) ; en particulier plus de 60 %, 70 %, 80 %, 90 % de la surface principale (110) ; ou
- sur toute l'aire de la surface principale (110).

6. Capteur optique intégré 3D selon l'une des revendications 1 à 5, sachant que la couche de filtre (400) s'étend sur la même aire que la couche d'entretoise (500) transparente.

7. Capteur optique intégré 3D selon l'une des revendications 1 à 6, sachant que
- la couche de filtre (400) est au moins en partie encadrée par une structure de blocage de lumière (410),
- la structure de blocage de lumière (410) est agencée au niveau d'une aire de bord de la surface principale (110).

8. Capteur optique intégré 3D selon l'une des revendications 1 à 7, sachant qu'un réseau d'orifices (520) est agencé au-dessus ou en dessous de la couche de filtre (400).

9. Capteur optique intégré 3D selon la revendication 8, sachant que le réseau d'orifices comprend un empilement de couches de métal, comprenant en outre :
- une couche opaque supérieure (M1) tournée à l'opposé de l'aire sensible à la lumière (210) et présentant des premiers orifices (AM1),
- une couche opaque inférieure (M2) faisant face à l'aire sensible à la lumière (210) et présentant des deuxièmes orifices (AM2), sachant que chaque premier et deuxième orifice (AM1, AM2) délimite un chemin optique dans le réseau d'orifices (2), respectivement,
- les bases supérieure et inférieure (M1, M2) sont composées de métal, et
- les chemins optiques sont conçus pour permettre à de la lumière incidente d'atteindre l'aire sensible à la lumière (210) lorsqu'elle présente un angle d'incidence à partir d'un intervalle permis d'angles (INT) déterminé par la taille des premier et deuxième orifices (AM1, AM2) et définis par rapport à un axe optique (OA) des chemins optiques, respectivement.

10. Capteur optique intégré 3D selon la revendication 8, sachant que le réseau d'orifices comprend une couche d'orifices (520) pourvue d'un réseau de zones d'orifices (36) transparentes au-dessus de la couche de filtre, chacune des zones d'orifices (36) pénétrant dans la couche d'orifices (520) .

11. Capteur optique intégré 3D selon l'une des revendications 1 à 10, sachant que la filerie comprend
- au moins une interconnexion verticale de substrat (5) connectée électriquement à une couche de redistribution agencée sur un verso du substrat semiconducteur (100) opposé à la surface principale, ou
- des pastilles de liaison (21) agencées dans ou sur la surface principale du substrat semiconducteur (100).

12. Procédé de production d'un capteur optique intégré 3D, comprenant les étapes de :
- mise à disposition d'un substrat semiconducteur (100) présentant un circuit intégré (200) comprenant au moins une aire sensible à la lumière et est agencée dans le substrat (100) au niveau ou près de la surface principale (110) ,
- agencement d'une filerie (300) sur ou dans le substrat semiconducteur (100) et connexion de la filerie (300) au circuit intégré (200),
- agencement d'une couche de filtre (400) sur le circuit intégré (200) de sorte que la couche de filtre (400) recouvre au moins l'aire sensible à la lumière (210), sachant que la couche de filtre (400) comprend un filtre d'interférence et/ou un filtre plasmonique,
- agencement d'une couche d'entretoise (500) transparente sur la couche de filtre (400) et enfermement au moins partiel de la couche de filtre (400), sachant que la couche d'entretoise (500) transparente est agencée directement sur la couche de filtre (400), et
- agencement d'un diffuseur sur puce (600) directement sur la couche d'entretoise (500) transparente et sur la couche de filtre (400),
**caractérisé en ce que**
- une épaisseur d'entretoise est agencée pour limiter un décalage spectral de la couche de filtre (400) de sorte que le décalage spectral soit constant ou compris dans ± 5 nm sous des angles d'incidence à partir d'un intervalle inférieur à ± 30°, sachant qu'une longueur d'onde centrale de la couche de filtre (400) est définie par rapport à une incidence normale et est spectralement décalée lorsque l'angle d'incidence de lumière frappant la couche de filtre (400) augmente.

13. Procédé selon la revendication 12, sachant qu'un réseau d'orifices (420) est agencé au-dessus ou en dessous de la couche de filtre (400) moyennant un processus CMOS.
